# EUROPEAN PATENT SPECIFICATION

(11) **EP 0 464 608 B1**
(45) Date of publication and mention of the grant of the patent: **08.01.1997**
(21) Application number: 91110491.7
(22) Date of filing: 25.06.1991
(51) Int. Cl.: H01P 5/10, H03D 9/06

(54) **High frequency, wide band, triple balanced mixer**
Dreifacher Gegentakt-Breitbandmischer mit hoher Frequenz
Mélangeur haute fréquence équilibre trois fois à large bande

(30) Priority: 02.07.1990 US 546972
(43) Date of publication of application: 08.01.1992
(73) Proprietor: Hughes Aircraft Company, Los Angeles, California 90045-0066 (US)
(72) Inventor: Fordham, Owen D., Canoga Park, CA 91304 (US); Copeland, Wilbert B., Los Angeles, CA 90056 (US)
(74) Representative: Grünecker, Kinkeldey, Stockmair & Schwanhäusser Anwaltssozietät

(56) References cited:
- US-A- 4 125 810
- US-A- 4 186 352
- US-A- 4 245 356
- US-A- 4 355 421
- US-A- 4 736 165
- PROCEEDINGS OF THE 11TH EUROPEAN MICROWAVE CONFERENCE, 8-11SEPTEMBER 1981, PAGES 197-202, SEVENOAKS, KENT, GB. OXLEY AND LOWBRIDGE: "A BETTER UNDERSTANDING OF IMAGE RECOVERY MIXERS"
- CONFERENCE PROCEEDINGS OF THE 10th EUROPEAN MICROWAVE CONFERENCE,8-12 SEPT. 1980,PGS 722-726 SEVENOAKS, KENT, GB. KNOECHEL AND SCHLEGEL: "OCTAVE-BAND DOUBLE-BALANCED INTEGRATED FINLINE & MIXERS AT MM-WAVELENGTHS."

## Description

### BACKGROUND OF THE INVENTION

### 1. Field of the Invention

The invention relates generally to radio receivers and transmitters requiring the conversion of an incident signal of given frequency into an output signal of a different frequency, by additive or subtractive mixing with a high level auxiliary signal. The invention relates more particularly to triple balanced mixers having wide band attributes and capable of mixing high frequency signals with low distortion.

### 2. Description of the Related Art

A mixer receives two input signals, a low power radio frequency signal (RF) and a high power local oscillator signal (LO), and produces one output signal, an intermediate frequency signal (IF). Sinusoidal input signals will typically result in an output signal having frequency components at the sum and difference of the input signal frequencies. In addition, the output signal also includes sums and differences of multiples of the input signal frequencies. Typically, only the sum or difference of the input signals is desired, and the other signal components are filtered out.

Convention mixers may be of the active, passive or switching type. However, the developments of Schottky barrier diodes for passive mixers has made passive diode mixers more advantageous than the other types and passive diode mixers thus have gained more widespread use.

Triple balance mixers are composed of eight diodes and three baluns (or, more precisely, three balun pairs). One of the baluns are used for each of the ports. Triple balanced mixers offer greater dynamic range, better spur suppression and interport isolation, and allow higher IF port frequencies than double balanced mixers. The disadvantages of triple balanced mixers are their higher LO power requirement, their inability to go down to DC on the IF port and their higher cost.

It is a crucial consideration that mixer performance is adversely affected by relatively high input frequencies between the ports decreases and lead inductance, parasitic capacitance and physical location of the components all tend to degrade the performance of the mixer. Consequently, in many important ways, conventional mixers do not typically perform very well at such high frequencies.

In an attempt to improve the high frequency performance of such mixers, some prior art mixers have utilized waveguide ports. An example of a prior art mixer which utilizes a waveguide port is disclosed in US-A-4,691,380. This device is a double balance mixer adapted for use at high frequencies up to 35 Ghz. However, the device has the shortcommings of double balanced mixers above noted.

Other prior art mixers have sought to improve port isolation at such demanding high frequency applications by utilizing orthogonal structures. An example of a prior art mixer which utilizes an orthogonal hybrid-T junction of the RF and LO ports is disclosed in US-A-4,480,336. This mixer is either a single balanced or double balanced mixer and thus also has shortcomings typical for single and double balanced mixers.

Another prior art (US-A-4,355,421) triple balanced mixer as indicated in the precharacterizing part of claim 1 utilizes a system of three pairs of baluns and three sets of connectors to suspend a pair of packaged diode quad rings within a housing. The RF and LO baluns are disposed in the same plane and one parallel plane on a single sheet of dielectric material. The IF balun is mounted on the top surface of the sheet and comprises two windings of a transformer coupled to the pair of diode rings.

Although the best of such prior art triple balanced mixers are designed to operate at frequencies up to 26 Ghz, their performance above 20 Ghz is not very good.

A mixer is thus needed that can provide good port isolation, spur suppression and low conversion loss at high frequencies. A mixer is also needed that can achieve these results while providing wide band capabilities and low distortion.

### SUMMARY OF THE INVENTION

It is the principal object of the present invention to provide an improved triple balanced mixer capable of good performance with high frequency input signals and having wide bandwidth characteristics, high dynamic range and excellent spurious performance.

This object is solved by the features as claimed in claim 1.

Essentially the present invention extends the performance characteristics of conventional high performance triple balanced mixers to higher frequencies on the order of 38 Ghz depending on whether coaxial or waveguide ports are utilized.

It is commonly believed by those skilled in the art that it is impossible to build a triple balanced mixer capable of satisfactory performance at frequencies above 20 Ghz. This is because it is believed that the diode quads have capacitances and parasitic lead inductances which combined with the ribbon connector inductance result in the mixer circuit acting as a low pass filter thereby limiting the high frequency performance of the mixer. However, by connecting low capacitance beam lead diode quad rings directly to the balun that is expected to deliver the highest frequency signal (thereby omitting the use of a ribbon connector) and incorporating specially designed baluns these capacitances and parasitic inductances have been minimized. Consequently, the mixer of the present invention can process high frequency signals up to 50 Ghz while still retaining all the high performance attributes of conventional triple balanced mixers operating at relatively low frequencies.

The invention incorporates two beam lead diode quad rings positioned on opposite faces of a suitable dielectric sheet. A suitable housing for these components has RF, LO and IF ports (for the input and output signals) which are connected to three balun pairs. Suitable connectors connect two of the balun pairs to the rings. However, the other balun pair is connected directly to the diode rings without the use of a connector therebetween. Elimination of such a connector eliminates the inductance which such a connector would present. The port which presents the highest frequencies to the mixer is the one which would otherwise cause the greatest degree of performance degradation. Therefore, the connectors in the circuitry for this high frequency port are the ones that are preferably eliminated. Consequently, this novel circuitry for the high frequency port raises the upper limit of the high frequencies the mixer is capable of processing and thereby greatly enhances its performance.

The invention also utilizes baluns having a novel design to reduce the length of the connectors thereby reducing the inductances they present. In addition, the novel design of the baluns maximizes the parasitic shorted stub impedance of the baluns while also both minimizing connector length for two of the ports and eliminating the need for a connector for the other port. Thus, the unique balun design allows the mixer to retain its wide bandwidth (which it would otherwise have only at relatively low frequencies) while simultaneously extending its high frequency capability. Essentially, a unique feature of the baluns is the particular shape of their forked portions which are bent outwardly at their medial portions. This balun shape provides wide spacing of the forked portions (for most of their lengths) to maximize the shorted stub impedance i.e., the impedance between the prongs of the forked portions, and narrow spacing at the forked portions' ends to minimize the distance between the diode rings and forked portions thereby minimizing the distance the connectors are required to bridge and allowing direct connection of at least one pair of the baluns to the diode rings.

The housing has inner walls which form a cavity in approximately the central portion of the housing. The cavity contains the rings, baluns and balun connectors. The large dimensional size of the cavity minimizes electromagnetic coupling between primarily the baluns and the cavity walls which would otherwise upset the balance of the mixer.

### BRIEF DESCRIPTION OF THE DRAWINGS

In the accompanying drawings:
FIG. 1 is a perspective view of the mixer of the present invention;
FIG. 2 is a perspective view of a portion of the mixer of FIG. 1 showing the cavity thereof and the mixer components contained therein in more detail;
FIG. 3 is an equivalent circuit diagram of a representative balun of the mixer;
FIG. 4 is a schematic diagram of the mixer circuits;
FIG. 5 is an equivalent circuit diagram of the diode quad rings and IF circuits of the mixer as seen from the IF port;
FIG. 6 is an equivalent circuit diagram of the diode quad rings and LO circuits of the mixer as seen from the LO port;
FIG. 7 is a graphical representation of the operating characteristics of the mixer showing the mixer's conversion loss as a function of input frequency;
FIG. 8 is a graphical representation of the operating characteristics of the mixer showing the mixer's spur rejection as a function of the oscillator frequency;
FIG. 9a is a plan view of the top side of the preferred balun pair design used in the mixer;
FIG. 9b is a plan view of the bottom side of the preferred balun pair design used in the mixer;
FIG. 10 is a plan view of a more conventional balun pair design for use in the mixer;
FIG. 11 is a sectional view of the balun pair of FIG. 9a taken along lines 11 - 11.

### DESCRIPTION OF THE PREFERRED ENBODIMENT

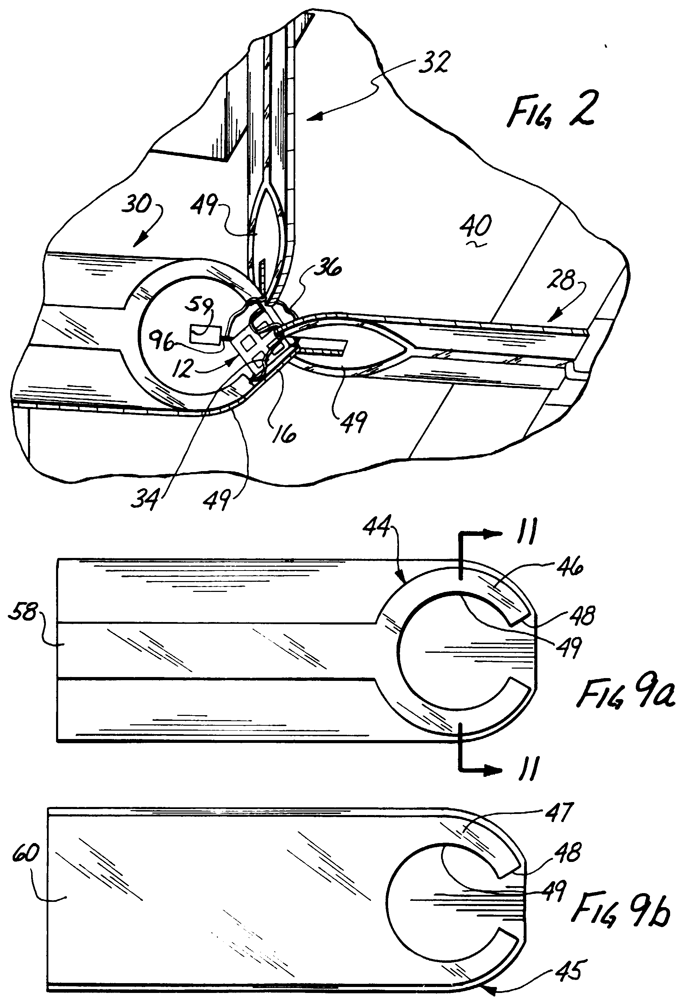

Referring now to the drawings, the mixer of the present invention is generally designated by the numeral 10. The mixer 10 preferably includes a pair of diode quad rings designated by the numerals 12 and 14. Rings 12 and 14 are preferably positioned on a suitable sheet 16 which is preferably composed of a fiber reinforced teflon (duroid) material. Rings 12 and 14 are preferably positioned on opposite faces of the sheet 16, as shown in FIG. 2.

The sheet 16 is preferably of a consistent thickness of approximately 0.127 mm. (5 mils). However, sheet 16 may also be of other suitable thicknesses and may be composed of materials other than duroid.

The mixer 10 preferably also includes a housing 20. The housing has an RF port 22, an LO port 24 and an IF port 26 for signal inputs and outputs to and from the mixer 10. An RF balun pair 28 is connected to the RF port. An LO balun pair 30 is connected to the LO port and an IF balun pair 32 is connected to the IF port 26. Balun pair 28 has preferably a line 58 positioned over a preferably parallel ground plane 60, as shown in FIGS. 9a and 9b which illustrate the top side and bottom side, respectively, of representative balun pair 28. Line 58 and ground plane 60 comprise an unbalanced microstrip transmission line. Line 58 and plane 60 feed a pair of balanced parallel strip transmission lines, or upper and lower forked portions 44 and 45, respectively. Balun pair 28 is preferably in the form of metallized patterns deposited on opposing faces of a duroid layer 18, which will be described in detail hereinbelow. Balun pair 30 similarly has preferably a line 62 and a preferably parallel ground plane 64 which similarly feed a pair of balanced parallel strip transmission lines or upper and lower forked portions 50 and 53, respectively. Balun pair 30 also preferably has a cut out portion or hole 59 at the center line of the balun pair 30 to accomodate one of the interconnectors 96. Hole 59 and interconnectors 96 will be described more in detail hereinbelow. Balun pair 32 similarly has a line 66 and a preferably parallel ground plane 68 which feed upper and lower forked portions 54 and 57, respectively. The balun pairs 28, 30 and 32 may be slotted to facilitate proximal positioning of the quad rings 12 and 14 and the balun pairs 28, 30 and 32 proximal each other, as shown in FIG. 2. However, either or all of the balun pairs 28, 30 and 32 may also be unslotted, as shown in FIGS. 9a and 9b.

Electrical connectors 34 and 36 interconnect the baluns 28 and 32 to appropriate terminals of the rings. The connectors 34 and 36 (or RF balun connectors 34 and IF balun connectors 36) are preferably thin, flat electrical conductors (ribbon connectors) which are of minimal length to minimize their lead inductance which would otherwise degrade the performance of the mixer 10.

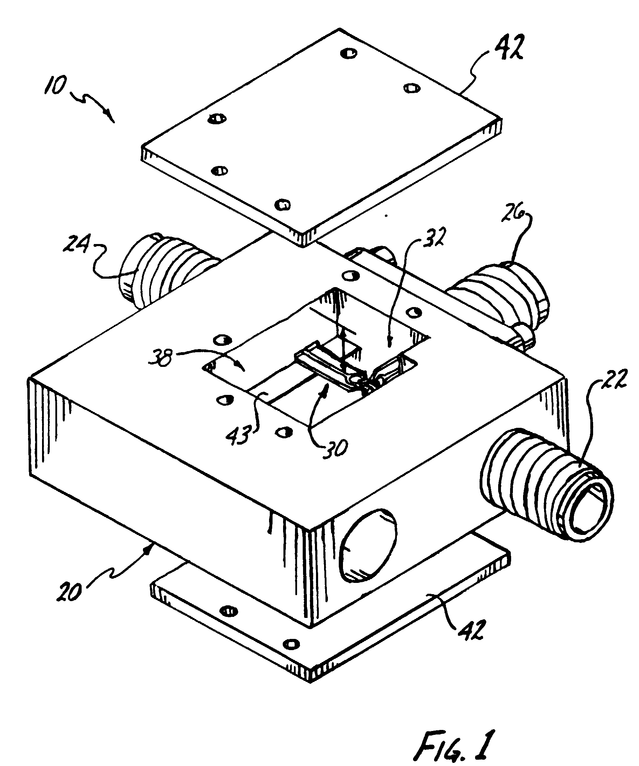

The rings 12 and 14, balun pairs 28, 30 and 32 and connectors 34 and 36 are disposed within a cavity 38 defined by lateral walls 40 and upper and lower walls 42 of the housing 20. The walls 40 and 42 are selectively dimensioned to maximize the dimensional size of the cavity 38 to minimize signal loss through electromagnetic interaction between the cavity walls and the rings, baluns and balun connectors. The walls 40 and 42 preferably have a height and width of approximately 5.08 mm. (200 mils) to provide a 2.54 mm. (100 mil) spacing between the baluns and walls, as shown in FIG. 1. It has been determined that this approximate spacing is optimum in that greater spacing does not significantly ameliorate signal loss. There are preferably windows 41 and shelf projections 43 at the lateral walls 40 which facilitate connection of the baluns 28, 30 and 32 to their respective ports. The housing 20 is preferably composed of a conductive material for connection of the ground side of the baluns (ground planes 60, 64 and 68) thereto.

The high frequency port may be any of the three ports depending on application requirements. However, to simplify the description of the mixer 10 design, the LO port and LO circuits will hereafter be designated as the high frequency port and high frequency circuits.

Since high frequencies degrade the performance of balanced mixers generally and triple balanced mixers in particular, it is most important that the inductances and capacitances of the high frequency LO circuits be minimized. The mixer 10 of the present invention accomplishes this at least partly by connecting the LO balun 30 directly to the diode ring terminals. This direct connection eliminates the need for a balun connector for the LO circuit thereby eliminating the inductance such a connector would present.

The RF and IF circuits do not carry frequencies as high as the LO port does. However, minimizing the length of the RF balun connectors 34 and IF balun connectors 36 reduces the lead inductances these connectors would otherwise present. Since the HPHSCH-9301 beam lead Schottky quad rings 12 and 14 which are preferably utilized (although other quad rings may also be suitable) are 0.356 mm. (14 mils) square not including leads (currently the smallest diode quads available), the length of the balun connectors 34 and 36 must accomodate the dimensions of the rings 12 and 14. Consequently, reduction of the length of the connectors 34 and 36 is limited by the dimensional size of the rings 12 and 14. As a result, the length of each of the balun connectors 34 and 36 is approximately 0.381 mm. (15 mils) and 0.508 mm. (20 mils), respectively, taking into consideration both the dimensions of the miniature rings 12 and 14 and the dimensions of the balun pairs 28 and 32, to be discussed more in detail hereinbelow.

Balun pairs 28; 30 and 32 are preferably generally similar in structure, dimensional shape and size. FIGS. 9a and 9b, depicting a representative balun pair, show the preferred shape for the balun pairs 28, 30 and 32 although either of (or all of) balun pairs 28, 30 and 32 may alternatively have the shape illustrated in FIG. 10, if desired. The representative balun pair illustrated in FIGS. 9a and 9b is designated as balun pair 28 for simplicity of description although the depicted features apply to the other balun pairs 30 and 32, as well. Balun pair 28 has upper (or top) forked portions 44 and lower (or bottom) forked portions 45, the top and bottom prongs 46 and 47 of which have medial portions 49 which are bent outwardly in order to maximize the spacing between the prongs 46 and 47 to thereby retain wide bandwidth. For example, the spacing of the medial portions 49 may be approximately 1.067 to 1.194 mm. (42 to 47 mils) at their points of widest separation. The wide spacing is limited by the length of the prongs which is determined by parameters which will be discussed in detail hereinbelow. The ends 48 of the prongs 46 and 47 have a narrower spacing to minimize the length of the balun connectors 34 which interconnect these ends 48 with the ring terminals in order to minimize inductance, as set forth hereinabove. For example, the narrow spacing of the ends 48 may be approximately 0.521 to 0.584 mm. (20.5 to 23 mils). The narrow spacing of the ends 48 is limited by the dimensions of the quad rings 12 and 14. Preferably, the forked portions 44 and 45 are generally curved around so that the forked portions 44 and 45 are generally in the shape of a circle open at one end. However, forked portions 44 and 45 may also have other suitable shapes as well. Forked portions 50 and 53 and prongs 51 and 52 of balun pair 30 and forked portions 54 and 57 and prongs 55 and 56 of balun pair 32 are essentially structurally identical to forked portions 44 and 45 and prongs 46 and 47 of balun pair 28, as described hereinabove.

Optionally, the more conventionally structured balun pair 31 depicted in FIG. 10 may be utilized. Balun pair 31 has upper and lower forked portions 33 and 35 with mostly straight top and bottom prongs 37 and 39, as shown. However, with this conventional design, the spacing between the prongs 37 and 39 must be tailored to suit the conflicting requirements of wide spacing to promote wide bandwidth and narrow spacing to minimize (or eliminate) balun connector length (and thereby balun connector inductance). A suitable compromise between these requirements results in a spacing of approximately 1.016 mm. (40 mils) between prongs 37 and 39. However, since utilization of miniature diode quad rings is desired because they provide low parasitic capacitance and inductance, incorporation of such baluns having generally straight prongs which require wide spacing would limit bandwidth of the mixer.

The spacing between the upper and lower forked portions 44 and 45 of the balun pair 28 is illustrated in FIG. 11. For simplicity of description, the forked portions and prongs depicted in FIG. 11 are referred to by the numerals 44, 45, 46 and 47 although they are representative of the other forked portions and prongs of balun pairs 30 and 32 which are essentially structurally identical and which have medial portions 49 and ends 48 which are preferably identically configured. FIG. 11 shows forked portions 44 and 45 which are preferably disposed in an upper and lower relationship and which preferably form a pair of parallel strip transmission lines. Balun pairs 28, 30 and 32 are preferably etched from metallization deposited on a dielectric, preferably a duroid (fiber reinforced teflon) layer 18. Thus, the duroid layer 18 is preferably positioned between the parallel forked portions 44 and 45 and preferably extends along the entire length of the balun pair 28. Portions of the duroid layer 18 between the prongs may be cut away (as shown in FIG. 2 with regard to balun pairs 28 and 32 in order to facilitate positioning of the diode rings between the prongs for electrical connection thereto. In addition, the sheet 16, also preferably composed of duroid, is preferably integral with the duroid layer 18, as shown in FIG. 2. Rings 12 and 14 are preferably adjacent opposite faces of sheet 16 so that rings 12 and 14 are not in contact with sheet 16. Rings 12 and 14 may also alternatively be positioned directly on opposite faces of a duroid layer 18 of one of the balun pairs 28, 30 or 32.

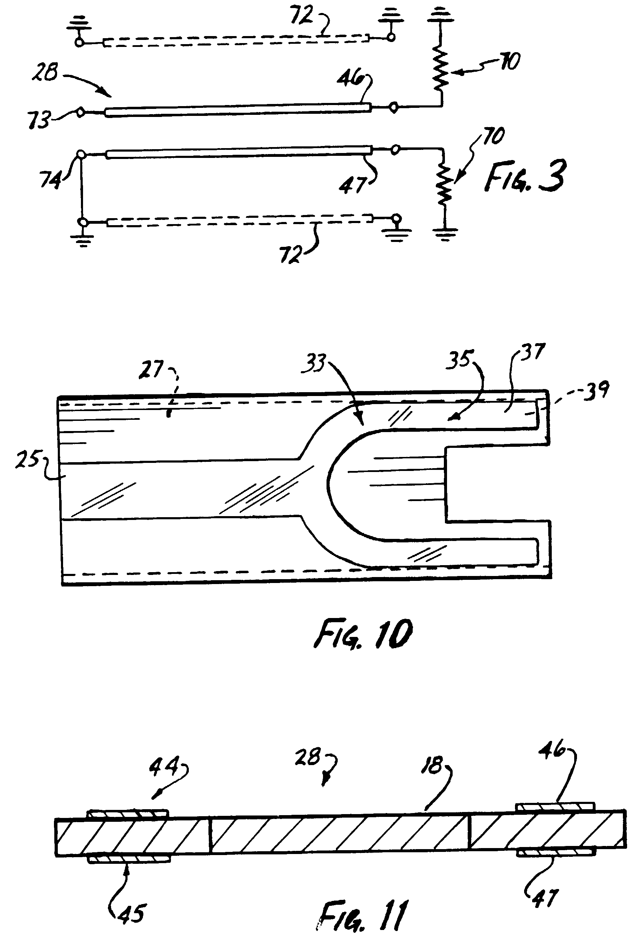

In order to match the balun pairs to their respective ports, the width of the prongs relative to the dielectric separating the parallel prongs was required. The impedance required for port match was found to be approximately 42 ohms (one-half of the impedance of the parallel forked portions). The equivalent circuit for one of the prongs 46 and a corresponding lower one of the prongs 47 of the representative balun pair 28 (identical for the other balun pairs 30 and 32) is shown in FIG. 3. Input node 73 and ground node 74 for the RF port are depicted as connected to resistors 70. The resistors 70 represent an equivalent resistance of diodes in parallel from the rings 12 and 14. Part of the signal is coupled to the housing walls which are represented by structure 72, depicted in phantom. The even mode propagates between the prongs 46 and 47 and the housing walls which are represented by structure 72, depicted in phantom. A shorted stub transmission line, which degrades balance, is formed by prong 47 shorted to the housing walls 72. A high even mode impedance (preferably approximately 400 ohms) is desired to minimize this coupling. The separation between the prongs and the housing walls controls this parameter.

In order to match the effective diode impedance to the port impedances (50 ohms), the ratio of prong width to dielectric thickness was selected. For the specific diodes mentioned hereinabove, a parallel strip impedance (forked portions impedance) of 84 ohms was required for match to 50 ohms. The spacing between the forked portions 44 and 45 is set by the duroid 18 and is preferably approximately 0.127 mm. (5 mils). A width/height ratio of 2.0 is preferred in order to realize an 84 ohm impedance in a duroid of dielectric constant of 2.2 (an effective dielectric of 1.92 thereby resulted). Thus, the width of the prongs 46, 47, 51, 52, 55 and 56 is 0.254 mm. (10 mils). The thickness of the duroid 18 and therefore the spacing between the prongs 46, 47, 52, 55 and 56 is relatively thin, preferably 0.127 mm. (5 mils), in order to minimize the ratio of prong width to length and to minimize parasitics due to connections between the forked portions 44, 45, 50, 53, 54 and 57 of each of the balun pairs 28, 30 and 32.

The length of the prongs of the forked portions 44, 45, 50, 53, 54 and 57 is preferably equal to a quarter wavelength of a 26 Ghz signal to yield reasonable performance from 12 Ghz to 40 Ghz which is the expected and preferred operating range of the mixer. However, the length of the prongs of the forked portions may be other lengths depending on the desired operating frequency range of the mixer 10.

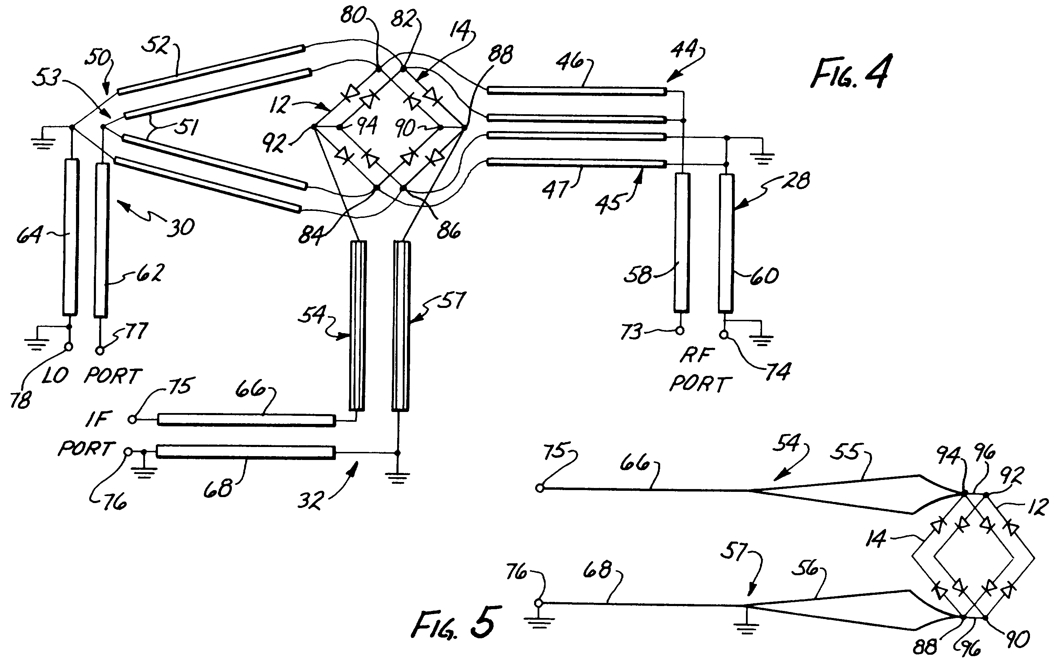

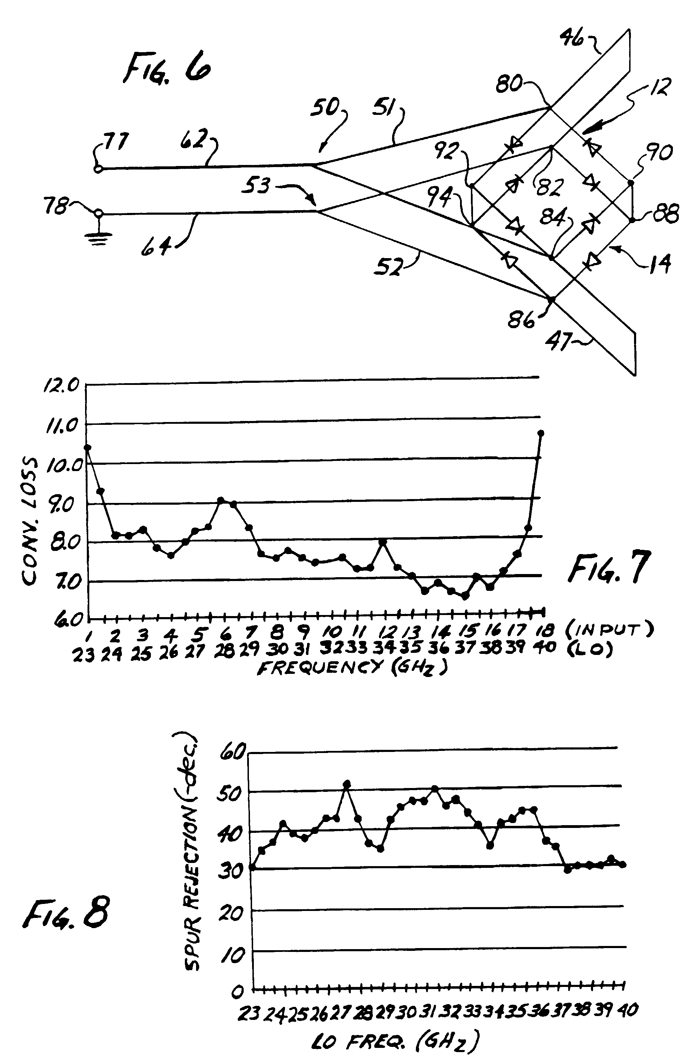

FIG. 4 shows the balun connections to the particular terminals (or sets of terminals) of the diode rings 12 and 14 in more detail. Balun pairs 28, 30 and 32 are preferably orthogonally positioned (as shown) in order to enhance port isolation. The input node 73 of the RF port 22 is connected to the terminals 80 and 82 of rings 12 and 14 via RF balun pair 28 while the ground node 74 of the RF port 22 is connected to the terminals 84 and 86 of rings 12 and 14 via RF balun pair 28. The LO circuit connections are somewhat different. As shown in FIGS. 4 and 6, the input node 77 of the LO port 24 is connected to terminals 80 and 84 of diode ring 12 via LO balun pair 30 while the ground node 78 of the LO port 24 is connected to terminals 82 and 86 of diode ring 14 via LO balun pair 30. The IF circuit connections are similar in some respects to the RF circuit connections. The input node 75 of the IF port 26 is connected to the diode ring terminals 92 and 94 which are interconnected by a suitable interconnector 96 (or simply directly connected together, if desired). Interconnector 96 for the terminals 92 and 94 preferably passes through a cut out or window 59 in duroid layer 18 to facilitate interconnection of the terminals 92 and 94. Alternatively, terminals 92 and 94 may be interconnected via a bonding pad (not shown) to which the interconnector 96 is electrically connected. The bonding pad may be a metallization extending through the duroid layer 18. The ground node 76 of the IF port 26 is connected to the diode ring terminals 88 and 90 which are also interconnected by an interconnector 96 (or simply directly connected together, if desired). The forked portions of each of the IF balun pair 32 are connected together preferably at their connection to the ring terminals.

The equivalent circuit seen at the LO port 24 is shown in FIG. 6. Terminals 88, 90, 92 and 94 appear as virtual grounds to the LO balun pair which thus sees a balanced load of two diodes in parallel on each side. The RF balun pair appears as shorted stubs across terminals 80 and 82 and across 84 and 86. The equivalent circuit seen at the RF port 22 is virtually identical to that of FIG. 6, except that the LO balun pair 30 appears as shorted stubs across nodes 80 and 84 and 82 and 86. The equivalent circuit seen at the IF port 26 is different and is shown in FIG. 5. The four shorted stubs formed by the LO and RF balun pairs are connected between four terminals at virtual ground; consequently, the LO and RF balun pairs have no effect on IF port match or balance.

The mixer 10 of the present invention can be used for either upconversion or downconversion providing excellent performance in either application. FIGS. 7 and 8 depict the performance characteristics of the mixer 10 when used as an upconverter. FIG. 7 shows the conversion loss (in db) to be good when signal input is within the range of 2 to 17.5 Ghz and LO signal input is within the range of 23 to 40 Ghz with a fixed output of 22 Ghz. FIG. 8 depicts the 2,0 spur rejection performance to be also good with an 11 Ghz interference signal at -10 dBm with high LO input frequencies within the range of 23 to 40 Ghz. Incorporation of a waveguide port (not shown) can extend the excellent performance of the mixer 10 to approximately 50 Ghz. Utilization of a waveguide port has been shown to extend the performance of the mixer 10 to approximately 46 Ghz and above with only 6db of conversion loss.

Accordingly, there has been provided, in accordance with the invention, a radio receiver and transmitter mixer which fully satisfies the objectives set forth above. It is to be understood that all terms used herein are descriptive rather than limiting.

## Claims

1. A triple balanced mixer, comprising:
a pair of diode quad rings (12, 14);
a housing (20) having walls (40,42) at least partially defining a cavity (38), said pair of diode quad rings (12,14) being positioned within said cavity (38);
a RF port (22) mounted on said housing (20) ;
an IF port (26) mounted on said housing (20);
a LO port (24) mounted on said housing (20):
an RF balun pair (28) for electrical communication between said RF port (22) and said pair of rings (12,14), said RF balun pair (28) having forked portions (44,45) which are bent so that the ends (48) of prongs (46,47) of said forked portions (44,45) are closer together than approximately medial portions (49) of the prongs (46,47);
and IF balun pair (32) for electrical communication between said IF port (26) and said pair of rings (12,14),
an LO balun pair (30) for electrical communication between said LO port (24) and pair of rings (12,14), said LO balun pair (30) having forked portions (50,53) which are bent so that ends (48) of prongs (51,52) of said forked portions (50,53) are closer together than approximately medial portions (49) of the prongs (51,52);
**characterized in that**
a) said IF balun pair (32) having forked portions (54,57) which are bent so that ends (48) of the prongs (55,56) of said forked portions are closer together than approximately medial portions (49) of the prongs (55,56)
b) said RF,IF and LO balun pairs (28,30,32) are generally orthogonally positioned relative to each other in order to enhance port signal isolation of the mixer, and
c) wherein the ends (48) of the LO balun pair (51,52) are directly connected to selected terminals (80,82,84,86) of said pair of rings (12,14).

2. The mixer of claim 1, further including:
an RF balun connector (34) interconnecting said RF balun pair (28) and selected terminals (80,82,84,86) of said pair of rings (12,14); and
an IF balun connector (36) interconnecting said IF balun pair (32) and selected terminals (88,90,92,94) of said pair of rings (12,14).

3. The mixer of claim 1 or 2 wherein said forked portions (44,45,50,53,54,57) of said RF,IF, and LO balun pairs (28,30,32) are curved around so that said forked portions (33,35,44,45,50,53) are generally in the shape of a circular arc.

4. The mixer of any one of claims 1 to 3, wherein said RF balun pair (28) includes an RF line (58) and RF upper forked portions (44) and an RF ground plane (60) and RF lower forked portions (45) separated by a layer (18).

5. The mixer of any one of claims 1 to 4, wherein said IF balun pair (32) includes an IF line (66) and IF upper forked portions (54) and an IF ground plane (68) and IF lower forked portions (57) separated by a layer (18).

6. The mixer of any one of claims 1 to 5, wherein said LO balun pair (30) includes an LO line (62) and LO upper forked portions (50) and an LO ground plane (64) and LO lower forked portions (53) separated by a layer (18).

7. The mixer of any one of claims 4 to 6, wherein said layer (18) is composed of a dielectric material.

8. The mixer of claim 7, wherein said layer is composed of a duroid material and wherein said forked portions (44,45. 50,53,54,57) are approximately 0.254 mm. wide and said duroid layer (18) is approximately 0.127 mm. thick in order to provide a desired impedance of approximately 84 ohms to said balun pair (30,32).

9. The mixer of claim 8, wherein said pair of rings (12,14) are positioned on opposite faces of said duroid layer (18) separating said LO line (62) and said LO upper forked portions (50) from said LO plane (64) and said LO lower forked portions (53).

10. The mixer of claim 9, wherein said duroid layer (18) separating said LO line (62) and said LO upper portions (50) from said LO plane (64) and said LO lower portions (53) is of generally consistent thickness so that each of said pair of rings (12, 14) lies in a plane generally parallel to that of the other of said pair of rings (12,14).

11. The mixer of any one of claims 1 to 10, wherein the forked portions (44,45,50,53,54,57) of said balun pairs (28,30,32) are spaced approximately 1.143 mm. apart to maximize impedance and minimize inductance of said balun pairs (28,30,32).

12. The mixer of any one of claims 1 to 11, wherein the prongs (46,47,51,52,55,56) of the forked portions (44,45,50,53,54,57) of said balun pairs (28,30,32) have a length approximately equal to the quarter wavelength of a 26 Ghz signal to maximize performance of the mixer between a desired operating LO frequence signal range of 12 Ghz to 40 Ghz.

13. The mixer of any one of claims 1 to 12 wherein the walls (40,42) of said housing (20) are selectively dimensioned so that said RF,IF and LO baluns (28,30,32) are each approximately 2.54 mm. from a generally parallel one of said walls (40,42) to minimize electromagnetic coupling between said balun pairs (28,30,32) and said walls (40,42).

14. The mixer of claim 13, wherein said walls (40,42) include an electromagnetic energy absorbent material on their inner surfaces in order to minimize reflection of signal emitted for said pair of rings (12,14) and said balun pairs (28,30,32).

15. The mixer of any one of claims 1 to 14, wherein said pair of rings (12,14) are suspended from said RF,IF and LO balum pairs (28,30,32).

16. The mixer of claim 14 or 15 wherein the dimensions of said walls (40,42) are aproximately 5.08 mm square in order to provide approximately 2.54 mm. spacing between said balun pairs (28,30,32) and said walls (40,42) so that the cavity walls (40,42) and said balun pairs (28,30,32) have an even mode impedance of approximately 400 ohms to minimize signal loss from said balun pairs (28,30,32).

## Patentansprüche

1. Dreifacher abgeglichener Mischer mit einem Paar von Dioden-Viereckringen (12, 14);
einem Gehäuse (20) mit Wänden (40, 42), die mindestens teilweise einen Hohlraum (38) begrenzen, wobei das Paar von Dioden-Viereckringen (12, 14) innerhalb des Hohlraums (38) angeordnet ist;
einem Hochfrequenz-HF-Anschluß (22), der an dem Gehäuse (20) angebracht ist;
einem Zwischenfrequenz-ZF-Anschluß (26), der an dem Gehäuse (20) angebracht ist;
einem an dem Gehäuse (20) angebrachten LO-Anschluß (24) für einen örtlichen Oszillator;
einem HF-Balunpaar (28) zur elektrischen Verbindung zwischen dem HF-Anschluß (22) und dem Paar von Ringen (12, 14), wobei das HF-Balunpaar (28) gegabelte Teile (44, 45) hat, die so gebogen sind, daß die Enden (48) von Zinken (46, 47) der gegabelten Teile (44, 45) näher zusammen sind als annähernd mittlere Teile (49) der Zinken (46, 47);
einem ZF-Balunpaar (32) zur elektrischen Verbindung zwischen dem ZF-Anschluß (26) und dem Paar von Ringen (12, 14);
einem LO-Balunpaar (30) zur elektrischen Verbindung zwischen dem LO-Anschluß (24) und dem Paar von Ringen (12, 14), wobei das LO-Balunpaar (30) gegabelte Teile (50, 53) hat, die so gebogen sind, daß die Enden (48) von Zinken (51, 52) der gegabelten Teile (50, 53) näher zusammen sind als annähernd mittlere Teile (49) der Zinken (51, 52);
**dadurch gekennzeichnet**, daß
a) das ZF-Balunpaar (32) gegabelte Teile (54, 57) hat, die so gebogen sind, daß Enden (48) der Zinken (55, 56) der gegabelten Teile näher zusammen sind als annähernd mittlere Teile (49) der Zinken (55, 56);
b) die HF-, ZF- und LO-Balunpaare (28, 30, 32) im wesentlichen orthogonal zueinander angeordnet sind, um die Anschlußsignalisolation des Mischers zu verbessern, und
c) wobei die Enden (48) des LO-Balunpaares (51, 52) unmittelbar mit ausgewählten Anschlüssen (80, 82, 84, 86) der Paare von Ringen (12, 14) verbunden sind.

2. Mischer nach Anspruch 1, der außerdem umfaßt:
einen HF-Balunverbinder (34), der das HF-Balunpaar (28) und ausgewählte Anschlüsse (80, 82, 84, 86) des Paares von Ringen (12, 14) verbindet, und
einen ZF-Balunverbinder (36), der das ZF-Balunpaar (32) und ausgewählte Anschlüsse (88, 90, 92, 94) des Paares von Ringen (12, 14) verbindet.

3. Mischer nach Anspruch 1 oder 2, wobei die gegabelten Teile (44, 45, 50, 53, 54, 57) der HF-, ZF- und LO-Balunpaare (28, 30, 32) herumgebogen sind, so daß die gegabelten Teile (33, 35, 44, 45, 50, 53) im wesentlichen die Form eines Kreisbogen haben.

4. Mischer nach einem der Ansprüche 1 bis 3, wobei das HF-Balunpaar (28) eine HF-Leitung (58) und obere gegabelte HF-Teile (44) und eine HF-Masseebene (60) sowie untere gegabelte HF-Teile (45) umfaßt, die von einer Schicht (18) getrennt sind.

5. Mischer nach einem der Ansprüche 1 bis 4, wobei das ZF-Balunpaar (32) eine ZF-Leitung (66) und obere gegabelte ZF-Teile (54) sowie eine ZF-Masseebene (68) und untere gegabelte ZF-Teile (57) umfaßt, die von einer Schicht (18) getrennt sind.

6. Mischer nach einem der Ansprüche 1 bis 5, wobei das LO-Balunpaar (30) eine LO-Leitung (62) und obere gegabelte LO-Teile (50) sowie eine LO-Masseebene (64) und untere gegabelte LO-Teile (53) umfaßt, die von einer Schicht (18) getrennt sind.

7. Mischer nach einem der Ansprüche 4 bis 6, wobei die Schicht (18) aus einem dielektrischen Material gebildet ist.

8. Mischer nach Anspruch 7, wobei die Schicht aus einem Duroidmaterial gebildet ist und wobei die gegabelten Teile (44, 45, 50, 53, 54, 57) etwa 0,254 mm breit und die Duroidschicht (18) etwa 0,127 mm dick sind, um eine gewünschte Impedanz von etwa 84 Ohm dem Balunpaar (30, 32) zu geben.

9. Mischer nach Anspruch 8, wobei das Paar von Ringen (12, 14) an gegenüberliegenden Seiten der Duroidschicht (18) angeordnet sind, die die LO-Leitung (62) und die oberen gegabelten LO-Teile (50) von der LO-Ebene (64) und den unteren gegabelten LO-Teilen (53) trennt.

10. Mischer nach Anspruch 9, wobei die Duroidschicht (18), die die LO-Leitung (62) und die oberen LO-Teile (50) von der LO-Ebene (64) und den unteren LO-Teilen (53) trennt, von im wesentlichen gleicher Dicke ist, so daß jeder des Paares von Ringen (12, 14) in einer Ebene liegt, die im wesentlichen parallel zu der des anderen des Paares von Ringen (12, 14) ist.

11. Mischer nach einem der Ansprüche 1 bis 10, wobei die gegabelten Teile (44, 45, 50, 53, 54, 57) der Balunpaare (28, 30, 32) etwa 1,143 mm voneinander beabstandet sind, um die Impedanz maximal und die Induktivität der Balunpaare (28, 30, 32) minimal zu machen.

12. Mischer nach einem der Ansprüche 1 bis 11, wobei die Zinken (46, 47, 51, 52, 55, 56) der gegabelten Teile (44, 45, 50, 53, 54, 57) der Balunpaare (28, 30, 32) eine Länge haben, die etwa gleich einer Viertelwellenlänge eines 26 Ghz-Signals ist, um die Leistungsfähigkeit des Mischers in einem gewünschten Arbeits-LO-Frequenzsignalbereich zwischen 12 Ghz bis 40 Ghz maximal zu machen.

13. Mischer nach einem der Ansprüche 1 bis 12, wobei die Wände (40, 42) des Gehäuses (20) wahlweise so dimensioniert sind, daß die HF-, ZF- und LO-Balunpaare (28, 30, 32) jeweils etwa 2,54 mm von einer im wesentlichen parallelen einen der Wände (40, 42) entfernt sind, um die elektromagnetische Kopplung zwischen den Balunpaaren (28, 30, 32) und den Wänden (40, 42) minimal zu machen.

14. Mischer nach Anspruch 13, wobei die Wände (40, 42) ein elektromagtisches energieabsorbierendes Material auf ihren Innenflächen haben, um die Reflektion der von dem Paar von Ringen (12, 14) und den Balunpaaren (28, 30, 32) abgestrahlten Signale minimal zu machen.

15. Mischer nach einem der Ansprüche 1 bis 14, wobei das Paar von Ringen (12, 14) von den HF-, ZF- und LO-Balunpaaren (28, 30, 32) aufgehängt ist.

16. Mischer nach Anspruch 14 oder 15, wobei die Abmessungen der Wände (40, 42) etwa 5,08 mm im Quadrat sind, um Abstände von etwa 2,54 mm zwischen den Balunpaaren (28, 30, 32) und den Wänden (40, 42) vorzusehen, so daß die Hohlraumwände (40, 42) und die Balunpaare (28, 30, 32) eine Impedanz in der geraden Mode von etwa 400 Ohm haben, um Signalverluste der Balunpaare (28, 30, 32) minimal zu machen.

## Revendications

1. Mélangeur triple équilibré comprenant :
un couple d'anneaux (12,14) à quatre diodes;
un boîtier (20) possédant des parois (40,42) définissant au moins partiellement une cavité (38), ledit couple d'anneaux (12,14) à quatre diodes étant disposé à l'intérieur de ladite cavité (38);
un port HF (22) monté sur ledit boîtier (20);
un port FI (26) monté sur ledit boîtier (20);
un port LO (24) monté sur ledit boîtier (20);
un couple (28) de baluns HF pour établir une communication électrique entre ledit port HF (22) et ledit couple d'anneaux (12,14), ledit couple (28) de baluns HF comportant des parties fourchues (44,45), qui sont coudées de telle sorte que les extrémités (48) de dents (46,47) desdites parties fourchues (44,45) sont plus rapprochées que les parties approximativement médianes (49) des dents (46,47);
un couple (32) de baluns FI pour l'établissement d'une communication électrique entre ledit port FI (26) et ledit couple d'anneaux (12,14),
un couple (30) de baluns LO pour l'établissement d'une communication électrique entre ledit port LO (24) et ledit couple d'anneaux (12,14), ledit couple (30) de baluns LO comportant des parties fourchues (50,53) qui sont coudées de telle sorte que des extrémités (48) de dents (51,52) desdites parties fourchues (50,53) sont plus proches l'une de l'autre que des parties approximativement médianes (49) des dents (51,52);
caractérisé en ce que
a) ledit couple (32) de baluns FI comportant des parties fourchues (54,57), qui sont coudées de telle sorte que des extrémités (48) des dents (55,56) desdites parties fourchues, sont plus rapprochées l'une de l'autre que des parties approximativement médianes (49) des dents (55,56),
b) lesdits couples (28,30,32) de baluns HF, FI et LO sont positionnés d'une manière générale en étant réciproquement perpendiculaires de manière à améliorer l'isolation des signaux des ports du mélangeur, et
c) les extrémités (48) du couple (51,52) de baluns LO sont connectées directement à des bornes sélectionnées (80, 82,84,86) dudit couple d'anneaux (12,14).

2. Mélangeur selon la revendication 1, comprenant en outre :
un connecteur (34) des baluns HF interconnectant ledit couple (28) de baluns HF et des bornes sélectionnées (80,82, 84,86) dudit couple d'anneaux (12,14); et
un connecteur (36) de baluns FI interconnectant ledit couple (32) de baluns FI et des bornes sélectionnées (88, 90,92,94) dudit couple d'anneaux (12,14).

3. Mélangeur selon la revendication 1 ou 2, dans lequel lesdites parties fourchues (44,45,50,53,54,57) desdits couples (28,30,32) de baluns HF, FI et LO sont incurvées de sorte que lesdites parties fourchues (33,35,44,45, 50,53) possèdent d'une manière générale la forme d'un arc circulaire.

4. Mélangeur selon l'une quelconque des revendications 1 à 3, dans lequel ledit couple (28) de baluns HF comprend une ligne HF (58) et des parties fourchues supérieures HF (44) et un plan de masse HF (60) et des parties fourchues inférieures HF (45), séparés par une couche (18).

5. Mélangeur selon l'une quelconque des revendications 1 à 4, dans lequel ledit couple (32) de baluns FI comprend une ligne FI (66) et des parties fourchues supérieures FI (54) et un plan de masse FI (68) et des parties fourchues inférieures FI (57), séparés par une couche (18).

6. Mélangeur selon l'une quelconque des revendications 1 à 5, dans lequel ledit couple (32) de baluns LO comprend une ligne LO (62) et des parties fourchues supérieures LO (50) et un plan de masse LO (64) et des parties fourchues inférieures LO (53), séparés par une couche (18).

7. Mélangeur selon l'une quelconque des revendications 4 à 6, dans lequel ladite couche (18) est constituée d'un matériau diélectrique.

8. Mélangeur selon la revendication 7, dans lequel ladite couche est constituée d'un matériau à base de duroid et dans lequel lesdites parties fourchues (44,45,50,53,54, 57) possèdent une largeur d'environ 0,254 mm et ladite couche de duroid (18) possède une épaisseur d'environ 0,127 mm de manière à fournir une impédance désirée d'environ 84 ohms audit couple de baluns (30,32).

9. Mélangeur selon la revendication 8, dans lequel les anneaux dudit couple d'anneaux (12,14) sont disposés sur des faces opposées de ladite couche de duroid (18) séparant ladite ligne LO (62) et lesdites parties fourchues supérieures LO (50) par rapport audit plan LO (64) et auxdites parties fourchues inférieures LO (53).

10. Mélangeur selon la revendication 9, dans lequel ladite couche de duroid (18), séparant ladite ligne LO (62) et lesdites parties supérieures LO (50) par rapport audit plan LO (64) et auxdites parties inférieures LO (53), possède une épaisseur essentiellement uniforme de sorte que chaque anneau dudit couple d'anneaux (12,14) est situé dans un plan essentiellement parallèle à celui de l'autre anneau dudit couple d'anneaux (12,14).

11. Mélangeur selon l'une quelconque des revendications 1 à 10, dans lequel les parties fourchues (44,45, 50,53,54,57) desdits couples de baluns (28,30,32) sont séparées d'environ 1,143 mm pour rendre l'impédance maximale et réduire l'inductance desdits couples de baluns (28,30,32).

12. Mélangeur selon l'une quelconque des revendications 1 à 11, dans lequel les dents (46,47,51,52, 55,56) des parties fourchues (44,45,50,53,54,57) desdits couples de baluns (28,30,32) possèdent une longueur égale approximativement au quart de la longueur d'onde d'un signal à 26 GHz pour rendre maximale la performance du mélangeur entre une gamme désirée de 12 GHz à 40 GHz du signal de fréquence LO de fonctionnement.

13. Mélangeur selon l'une quelconque des revendications 1 à 12, dans lequel les parois (40,42) dudit boîtier (20) sont dimensionnées de façon sélective de telle sorte que lesdits baluns HF, FI et LO (28,30,32) sont situés chacun à environ 2,54 mm de l'une, essentiellement parallèle, desdites parois (40,42) pour réduire le couplage électromagnétique entre lesdits couples de baluns (28,30,32) et lesdites parois (40,42).

14. Mélangeur selon la revendication 13, dans lequel lesdites parois (40,42) comprennent un matériau absorbant l'énergie électromagnétique, sur leurs surfaces intérieures, de manière à réduire la réflexion du signal émis par ledit couple d'anneaux (12,14) et lesdits couples de baluns (28,30,32).

15. Mélangeur selon l'une quelconque des revendications 1 à 14, dans lequel les anneaux dudit couple d'anneaux (12,14) sont suspendus auxdits couples de baluns HF, FI et LO (28,30,32).

16. Mélangeur selon la revendication 14 ou 15, dans lequel les dimensions desdites parois (40,42) correspondent à un carré d'environ 5,08 mm de côté pour fournir un espacement d'environ 2,54 mm entre lesdits couples de baluns (28,30,32) et lesdites parois (40,42) de sorte que les parois (40,42) de la cavité et lesdits couples de baluns (28,30,32) possèdent une impédance de mode pair d'environ 400 ohms pour réduire la perte du signal à partir desdits couples de baluns (28,30,32).
